# EUROPEAN PATENT APPLICATION

(11) **EP 0 732 777 A2**
(43) Date of publication of application: **18.09.1996**
(21) Application number: 96301474.1
(22) Date of filing: 05.03.1996
(51) Int. Cl.: H01R 13/719

(54) **Electromagnetic interference suppressing connector array**

(30) Priority: 14.03.1995 US 403325
(71) Applicant: AT&T IPM Corp., Coral Gables, Florida 33134 (US)
(72) Inventor: Law, Henry Hon, Berkeley Heights, New Jersey 07922 (US)
(74) Representative: Johnston, Kenneth Graham

(57) **Abstract**

An EMI suppressing connector comprises a body of ferrite having a plurality of conductive channels and at least one planar surface. The channel walls are wholly or partially coated with conductive material which provides a conductive path extending through the body and the planar surface includes a pattern of coated conductive leads connected to the conductive channels. Preferably the connector is in the form of a rectangular parallelopiped, and the channels extend perpendicularly between two major surfaces. In one embodiment, the conductive material extends horizontally through the body and onto planar bottom. The conductive material on the planar bottom surface provides ready connection with contacts on a circuit board or IC package. In another embodiment, the conductive material extends vertically through the body and onto a planar bottom or top. The conductive material on the planar surface can be configured in any desired pattern to define fanouts or mappings from one set of contacts to another.

## Description

### Field of the Invention

This invention relates to electromagnetic interference (EMI) suppressing connectors and, in particular, to a device for providing an array of EMI suppressed connections to an electronic circuit board or IC package.

### Background of the Invention

As communications and consumer electronics moves to digital signaling with higher bit rates, suppression of electromagnetic interference assumes greater significance in product design. As portable products using microprocessors become common, there will be more potential sources of electromagnetic emission and more potential for interference by signals picked up. Moreover with higher bit rates, electromagnetic interference is a potential problem even within a complex unit such as a computer.

The most common approach to EMI suppression is to shield emitting and vulnerable components in metal cans. See, for example, P. Nyholm et al, "EMI Protection in Consumer Portable Products," Electronic Packaging and Production, pp. 40-44 (March 1994). This approach, however, becomes more difficult as bit rates increase. A more effective approach is shielding with soft ferrites. Cores, beads and connector plates have been used to provide such shielding. See C. Parker, "How to Select Ferrites and How They Work", EMC Test and Design, pp. 26-29 (January 1994). The difficulty with such devices is that they are difficult to use with electronic circuit boards and IC packages requiring a high density of connections. Accordingly, there is a need for a new EMI suppressing connector.

### Summary of the Invention

An EMI suppressing connector comprises a body of ferrite having a plurality of conductive channels and at least one planar surface. The channel walls are wholly or partially coated with conductive material which provides a conductive path extending through the body and the planar surface includes a pattern of coated conductive leads connected to the conductive channels. Preferably the connector is in the form of a rectangular parallelopiped, and the channels extend perpendicularly between two major surfaces. In one embodiment, the conductive material extends horizontally through the body and onto planar bottom. The conductive material on the planar bottom surface provides ready connection with contacts on a circuit board or IC package. In another embodiment, the conductive material extends vertically through the body and onto a planar bottom or top. The conductive material on the planar surface can be configured in any desired pattern to define fanouts or mappings from one set of contacts to another.

### Brief Description of the Drawings

In the drawings:
FIG. 1 is a perspective view of an EMI suppressing connector in accordance with a first embodiment of the invention;
FIG. 2 shows the back surface of the FIG. 1 device;
FIG. 3 shows the bottom surface of the FIG. 1 device;
FIG. 4 shows an alternative bottom surface; and
FIG. 5 illustrates the FIG. 1 device in use.
FIG. 6 is a perspective view of a second embodiment of the invention using vertical rather than horizontal channels; and
FIG. 7 is a cross sectional view of a third embodiment employing channels that are both vertical and horizontal.

### Detailed Description

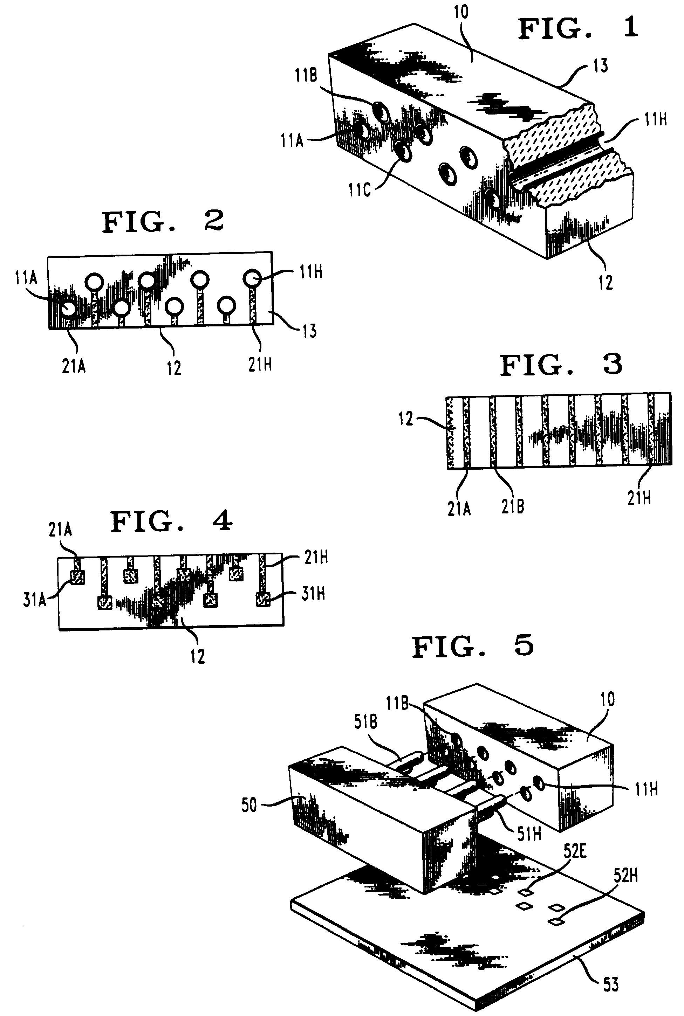

Referring to the drawings, FIG. 1 illustrates an EMI suppressing connector comprising a body 10 of ferrite material having an array of channels 11A-11H for receiving conductors (not shown) and at least one planar surface 12 (here the bottom surface). The walls of channels 11A-11H are coated with conductive material which extends through the body 10 and over the body surface (here the back surface 13) onto the planar bottom surface 12. As illustrated, the body 10 is preferably in the form of a rectangular parallelopiped with the channels extending perpendicularly between a pair of major surfaces.

The extension of the channel conductors can be seen in FIG. 2 which shows the back surface 13 having a linear array of conductors 21A-21H extending from channels 11A-11G down to bottom surface 12.

FIG. 3 shows the planar bottom surface 12 with conductors 21A-21H extending around the edge across the planar bottom surface.

FIG. 4 is an alternative bottom surface 12 where the conductors 21A-21H contact an array of bonding pads 31A-31H for providing contact with a corresponding array of bonding pads on an electronic circuit board or IC package. It will be appreciated that by appropriate patterning of the conductors on the bottom surface, any one of conductors 21A-21H can be mapped to any one (or more) of bonding pads 31A-31H.

FIG. 5 illustrates the preferred use of the device. An array 50 of contact pins 51A-51H is inserted into corresponding array of channels 11A-11H. The conductive paths from channels 11A-11H extend to the array of bonding pads 31A-31H on the bottom surface (not shown). These bonding pads contact a corresponding array of bonding pads 52A-52H on a circuit board or IC package 53. Thus, the contact pins are provided with EMI suppressed contacts with the board or package.

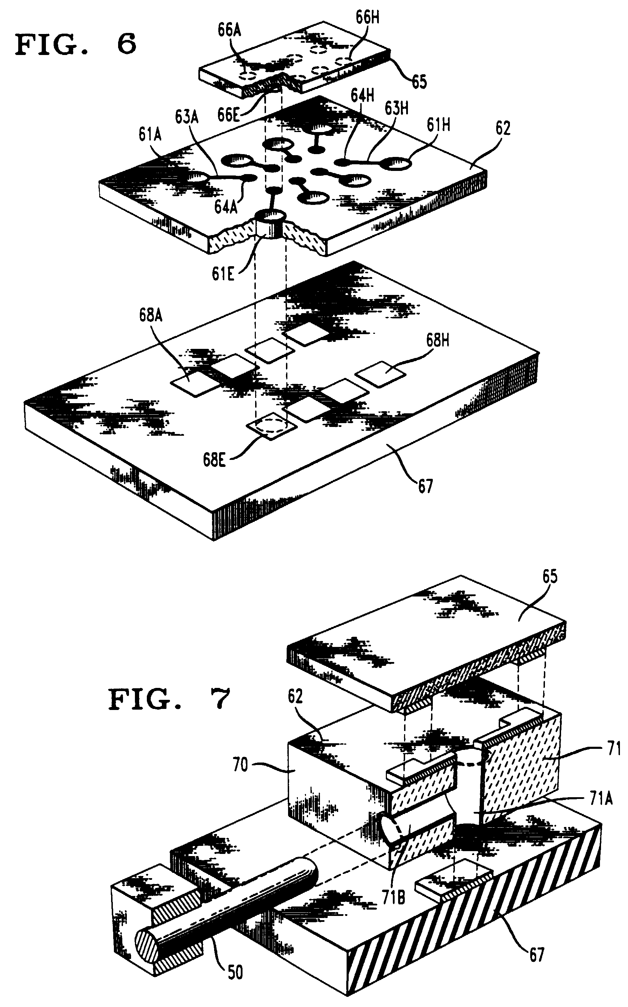

FIG. 6 is a perspective view of an alternative embodiment of an EMI suppressing connector having vertical channels 61A-61H rather than horizontal channels. In this embodiment the channels preferably extend between to parallel planar horizontal surfaces 62, and the conductive material in the channels is advantageously continuous with a pattern of conductors 63A-63H on one or both planar surfaces. Here the conductors 63A-63H provide a fan-out pattern from a closely spaced array of contact pads 64A-64H. Thus, an integrated circuit (65) having a closely spaced array of bonding pads 66A-66H can be bonded to array 64A-64H on top of the device. The bottom of the device can be bonded to a circuit board 67 having more widely spaced array of contact pads 68A-68H as by soldering the conductive channels 61 to the pads 68. Continuous conductive EMI suppressed paths are provided from the integrated circuit 65 through the conductors 63A-63H and through the vertical channels 61A-61H to an underlying circuit board 67.

FIG. 7 is a cross sectional view of a third embodiment of the device employing conductively coated channels 71 that are both vertical and horizontal. Specifically, the channel has a vertical component 71A extending between parallel surfaces 62 and a horizontal component 71B extending from surface 70 (perpendicular to 62) to at least the vertical component 71A. This device can provide conductive T-junctions, permitting interconnection among an array of horizontal contacts 50, an integrated circuit 65 and a PC board 67. For even greater connectivity, horizontal channel component 71B can extend through the body.

The invention can be understood in greater detail by consideration of the following specific example.

### Example 1

A ferrite substrate (11.4 x 26.7 mm) with two parallel rows of ten 1.1 mm diameter holes each, was obtained from Steward Inc. (Chattanooga, TN). Using a variable speed flexible-shaft hand-held grinder and a grinder bit (0.029" diameter), the pattern depicted in FIGs. 2 and 3 was grinded onto the ferrite piece. The trenches are about 16-20 mils wide and 2-3 mil deep. The ferrite piece was completely metallized by using the thermal reduction process described in United States patent application Serial No. 08/268487 filed on June 30, 1994. The ferrite sample was first heat-treated in a tubular furnace with a flowing forming gas (15%H₂ + 85%N₂) or nitrogen. The heat treatment consisted of heating from room temperature to 350°C in 30 minutes, holding it at 350°C for 45 minutes in forming gas, heating to and holding at 550°C in nitrogen for 15 minutes, and then furnace cooling. The metalized sample was then electroplated with 5 microns thick copper in a commercial acid sulfate copper plating bath (CUPRACID from Atotech, State College, PA), 2.5 microns of nickel from a commercial nickel sulfamate bath (Barrett, Allied Kelite Div., MacDermid, Waterbury, CT), and 1 micron of Au from a conventional gold bath. The metal layer on the front, back and bottom flat surfaces were removed by sanding leaving the inner surface of the holes and the trenches coated with gold/nickel/copper finish.

A printed circuit board with circular pads and lines matching the bottom surface of the ferrite sample was created using a quick prototyping tool. Conventional tin/lead solder paste were placed on the pads. After the ferrite sample was placed on solder paste, the printed circuit board was placed on a conventional conveyor belt furnace to reflow the solder. This EMI suppressing connector on printer circuit board is suitable for mounting IC chips or connecting to cable connectors.

## Claims

1. An electromagnetic interference suppressing connector device comprising:
a body of ferrite material, said body having a plurality of channels therethrough and having at least one planar surface;
said channels each including a conductive coating providing a continuous electrical path through said body;
said planar surface including a coated pattern of conductive leads, said leads electrically connected to respective conductive channel coatings.

2. A device according to claim 1, further comprising a plurality bonding pads on said planar surface wherein said conductive leads are connected to respective bonding pads.

3. A device according to claim 1 wherein said body has at least two planar surfaces and said channels extend between said two planar surfaces.

4. A device according to claim 1 wherein said bonding pads are configured in an array for electrically connecting to an integrated circuit.

5. A device according to claim 1 wherein said body comprises a rectangular parallelopiped having three mutually perpendicular pairs of parallel surfaces.

6. A device according to claim 5 wherein said channels extend between one pair of parallel surfaces and said conductive leads extend to a perpendicular surface.

7. A device according to claim 6 wherein said perpendicular surface includes a plurality of bonding pads and said conductive leads extend to respective ones of said bonding pads.

8. A device according to claim 5 wherein said channels each comprise a first channel extending between a first pair of parallel surfaces and an intersecting channel extending from a third surface perpendicular to said first pair.

9. A device comprising an integrated circuit and a circuit board, said integrated circuit connected to said circuit board through a connector device of claim 1.

10. A device for providing electromagnetic interference suppressing connectors to a circuit board having an array of bonding pads, said device comprising:
a body of ferrite material having a pair of parallel surfaces,
an array of channels extending between said parallel surfaces, each channel of said array corresponding to a bonding pad on said circuit board, and each said channel provided with a continuous conductive coating for contacting said bonding pad.

11. A device for providing electromagnetic interference suppressing connections to an integrated circuit having an array of bonding pads, said device comprising:
a body of ferrite material having a pair of parallel surfaces;
one of said surfaces having an array of bonding pads corresponding to said array of bonding pads on said integrated circuit;
a plurality of channels extending between said parallel surfaces, each said channel provided with a continuous conductive coating extending through said body; and
a plurality of conductive leads coated on said surface having bonding pads, said leads connecting respective bonding pads to respective conductively coated channels.
